(19) Europäisches Patentamt / European Patent Office / Office européen des brevets

(11) **EP 4 367 523 B1**

(12) # FASCICULE DE BREVET EUROPEEN

(45) Date de publication et mention
de la délivrance du brevet:
**23.07.2025   Bulletin 2025/30**

(21) Numéro de dépôt: **22737643.1**

(22) Date de dépôt: **06.07.2022**

(51) Classification Internationale des Brevets (IPC):
*G01R 31/367* (2019.01)

(52) Classification Coopérative des Brevets (CPC):
**G01R 31/367**; G01R 31/3842

(86) Numéro de dépôt international:
**PCT/EP2022/068713**

(87) Numéro de publication internationale:
**WO 2023/280907 (12.01.2023 Gazette 2023/02)**

(54) **PROCÉDÉ D'ESTIMATION DE L'ÉTAT DE CHARGE D'UN ÉLÉMENT ÉLECTROCHIMIQUE ET DISPOSITIFS ASSOCIÉS**

VERFAHREN ZUR SCHÄTZUNG DES LADEZUSTANDES EINES ELEKTROCHEMISCHEN ELEMENTS UND ZUGEHÖRIGE VORRICHTUNGEN

METHOD FOR ESTIMATING THE STATE OF CHARGE OF AN ELECTROCHEMICAL ELEMENT AND ASSOCIATED DEVICES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **06.07.2021  FR 2107294**

(43) Date de publication de la demande:
**15.05.2024   Bulletin 2024/20**

(73) Titulaire: **SAFT**
**92300 Levallois-Perret (FR)**

(72) Inventeurs:
• **MONIER-REYES, Daniel**
**33480 AVENSAN (FR)**
• **BENJAMIN, Sébastien**
**33850 LEOGNAN (FR)**

(74) Mandataire: **Lavoix**
**2, place d'Estienne d'Orves**
**75441 Paris Cedex 09 (FR)**

(56) Documents cités:
• DONG CHAO ET AL: "Estimation of power battery SOC based on improved BP neural network", 2014 IEEE INTERNATIONAL CONFERENCE ON MECHATRONICS AND AUTOMATION, IEEE, 3 August 2014 (2014-08-03), pages 2022 - 2027, XP032633697, ISBN: 978-1-4799-3978-7, [retrieved on 20140827], DOI: 10.1109/ICMA.2014.6886014
• PU SHI ET AL: "The ANN models for SOC/BRC estimation of li-ion battery", INFORMATION ACQUISITION, 2005 IEEE INTERNATIONAL CONFERENCE ON HONG KONG AND MACAU, CHINA JUNE 27 - JULY 3, 2005, PISCATAWAY, NJ, USA,IEEE, 27 June 2005 (2005-06-27), pages 560 - 564, XP010918620, ISBN: 978-0-7803-9303-5
• HOW DICKSON N T ET AL: "State of Charge Estimation for Lithium-Ion Batteries Using Model-Based and Data-Driven Methods: A Review", IEEE ACCESS, vol. 7, 18 September 2019 (2019-09-18), pages 136116 - 136136, XP011747974, DOI: 10.1109/ ACCESS.2019.2942213

**Description**

La présente invention concerne un procédé d'estimation de l'état de charge d'au moins un élément électrochimique d'une batterie. La présente invention se rapporte aussi à un calculateur, un système de gestion et une batterie associés.

Typiquement une batterie comprend un ou plusieurs accumulateurs de courant appelés aussi générateurs électrochimiques, cellules ou éléments. Un accumulateur est un dispositif de production d'électricité dans lequel de l'énergie chimique est convertie en énergie électrique. L'énergie chimique provient des composés électrochimiquement actifs déposés sur au moins une face d'électrodes disposées dans l'accumulateur. L'énergie électrique est produite par des réactions électrochimiques au cours d'une décharge de l'accumulateur. Les électrodes, disposées dans un conteneur, sont connectées électriquement à des bornes de sortie de courant qui assurent une continuité électrique entre les électrodes et un consommateur électrique auquel l'accumulateur est associé.

Afin d'augmenter la puissance électrique délivrée, on peut associer plusieurs accumulateurs étanches entre eux pour former une batterie. Ainsi, une batterie peut être divisée en modules, chaque module étant composé d'un ou plusieurs accumulateurs reliés entre eux en série et/ou en parallèle. Ainsi, une batterie peut par exemple comporter une ou plusieurs branches parallèles d'accumulateurs reliés en série et/ou une ou plusieurs branches parallèles de modules reliés en série.

Un circuit de charge est généralement prévu auquel la batterie peut être branchée pour recharger les accumulateurs.

Par ailleurs, un système de gestion électronique comprenant des capteurs de mesures et un circuit électronique de contrôle, plus ou moins évolué selon les applications, peut être associé à la batterie. Un tel système permet notamment d'organiser et de contrôler la charge et la décharge de la batterie, pour équilibrer la charge et la décharge des différents accumulateurs de la batterie les uns par rapport aux autres.

L'état de charge est une information utile au système électronique de gestion de la batterie pour optimiser son utilisation et sa durée de vie. L'état de charge est souvent désigné par l'abréviation SOC qui renvoie à la dénomination anglaise de « State of Charge ».

Pour obtenir l'état de charge SOC, il est connu d'utiliser deux techniques de calcul utilisant des mesures continues de l'évolution de la tension, du courant et de la température.

La première technique peut être qualifiée de « coulométrique » dans la mesure où il est utilisé le fait que l'état de charge SOC dépend de la charge (comptage des Ampères-heures) et de la capacité C de la batterie.

En effet, il vient les formules suivantes :

$$SOC = SOC_0 + \frac{\int_0^t I \times dt}{C}$$

Où : $SOC_0$ est la valeur initiale de l'état de charge SOC à l'instant t=0.

Toutefois, cette première technique est très sensible à l'erreur de mesure en courant ainsi qu'à l'estimation de la capacité. De ce fait, l'utilisation seule de cette technique conduit à de l'accumulation de l'erreur de mesure du courant, ce qui induit une estimation erronée de l'état de charge.

La deuxième technique est basée sur les mesures de la tension en circuit ouvert OCV et utilise une table de correspondance préétablie pour obtenir l'état de charge SOC en fonction de la tension en circuit ouvert. La tension en circuit ouvert est souvent désignée par l'abréviation OCV qui renvoie à la dénomination anglaise de « Open Circuit Voltage ».

Comme la fonction qui lie la tension en circuit ouvert OCV à l'état de charge SOC est une fonction de la tension à laquelle est soustraite le produit de la résistance par le courant, la deuxième technique est une technique sensible à l'estimation de la résistance. Aussi, il convient d'utiliser la deuxième technique dans des conditions permettant de minimiser l'erreur sur la résistance, à savoir des conditions de repos ou de courant faible.

Il est connu d'utiliser les deux techniques précitées en utilisant la première technique comme technique habituelle et en recalibrant de manière régulière l'état de charge SOC à l'aide de la deuxième technique.

Toutefois, dans certains éléments électrochimiques, du fait que la variation de la tension en circuit ouvert en fonction de l'état de charge SOC présente un plateau, la correspondance entre la tension en circuit ouvert OCV et l'état de charge SOC peut être fausse.

Ainsi, il est connu d'effectuer un recalage en effectuant une recharge avec un état de charge SOC supérieur à l'état de charge SOC maximal correspondant à la fin du plateau.

Une telle technique impose alors généralement l'interruption de la mission de l'élément électrochimique pour effectuer la recharge. C'est notamment le cas pour des missions de régulation de fréquence qui impliquent des cycles sur le plateau. De telles interruptions peuvent être incompatibles avec la mission.

Il est également connu des procédés d'estimation de l'état de charge des articles suivants :

- un article de Dong CHAO et al. intitulé « Estimation of Power battery SOC based on improved BP neural network » (2014 IEEE International Conference on Mechatronics and Automation),
- un article de Pu CHI et al. intitulé « The ANN models for SOC/BRC estimation of li-ion battery » (Information Acquisition, 2005 IEEE International Conference on Hong Kong and Macao, China), et
- un article de HOW DICKSON N. T. et al. intitulé « State of Charge Estimation for Lithium-Ion Batteries Using Model-Based and Data-Dirven Methods: A Review » (IEEE Access, vol. 7, pages 136116-136136).

Il existe donc un besoin pour un procédé d'estimation de l'état de charge SOC d'un élément électrochimique qui soit plus précis et réalisable en fonctionnement normal de l'élément électrochimique.

A cet effet, la description décrit un procédé d'estimation de l'état de charge d'au moins un élément électrochimique d'une batterie, le procédé étant selon la revendication 1.

Selon des modes de réalisation particuliers, le procédé d'estimation présente une ou plusieurs des caractéristiques des revendications 2 à 8, prise(s) isolément ou selon toutes les combinaisons techniquement possibles.

La description propose également un calculateur propre à estimer l'état de charge d'au moins un élément électrochimique d'une batterie selon la revendication 9.

Selon un mode de réalisation particulier, le calculateur est propre à corriger la quantité de charge accumulée calculée utilisée par la deuxième technique pour que le calcul de la deuxième technique conduise à obtenir la première valeur calculée de l'état de charge lorsque la première technique est déterminée comme fiable.

La description décrit aussi un système de gestion d'au moins un élément électrochimique d'une batterie, l'au moins un élément électrochimique présentant des bornes, le système de gestion comprenant un capteur de tension propre à mesurer la tension aux bornes dudit au moins un élément électrochimique, un capteur du courant aux bornes dudit au moins un élément électrochimique, un capteur de température dudit au moins un élément électrochimique, et un calculateur tel que décrit précédemment.

La description propose également une batterie comprenant au moins un élément électrochimique, et un système de gestion tel que décrit précédemment.

Des caractéristiques et avantages de l'invention apparaîtront à la lecture de la description qui va suivre, donnée uniquement à titre d'exemple non limitatif, et faite en référence aux dessins annexés, sur lesquels :

- la figure 1 est une représentation schématique d'un exemple de batterie comportant un élément électrochimique,
- la figure 2 est un graphe illustrant un exemple de caractéristique état de charge - tension en circuit ouvert de l'élément électrochimique de la figure 1,
- la figure 3 est un ordinogramme d'un exemple de mise en œuvre de procédé d'estimation de l'état de charge de l'élément électrochimique, et
- les figures 4 à 8 illustrent des courbes expérimentales pouvant être obtenues à l'issue de la mise en œuvre de certaines étapes du procédé d'estimation décrit à la figure 3.

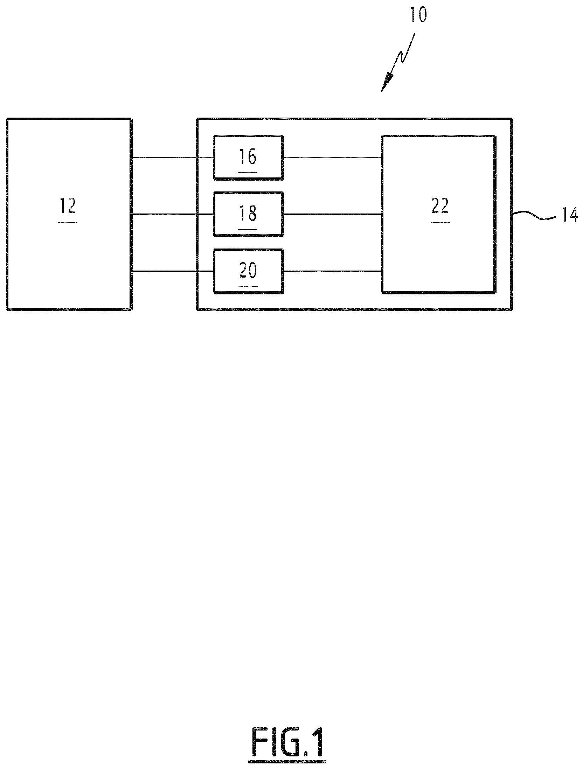

Une batterie 10 est représentée sur la figure 1.

De manière connue en soi, une batterie est généralement un agencement d'une pluralité d'éléments électrochimiques mais dans un souci de simplification du propos, il est décrit un cas à un seul élément électrochimique dans ce qui suit, sachant que la transposition à d'autres agencements est immédiate.

La batterie 10 comporte un élément électrochimique 12 et un système de gestion 14 de l'élément électrochimique 12.

Comme expliqué précédemment, un élément électrochimique 12 est un dispositif de production d'électricité dans lequel de l'énergie chimique est convertie en énergie électrique.

L'élément électrochimique 12 délivre donc un courant et une tension entre deux bornes.

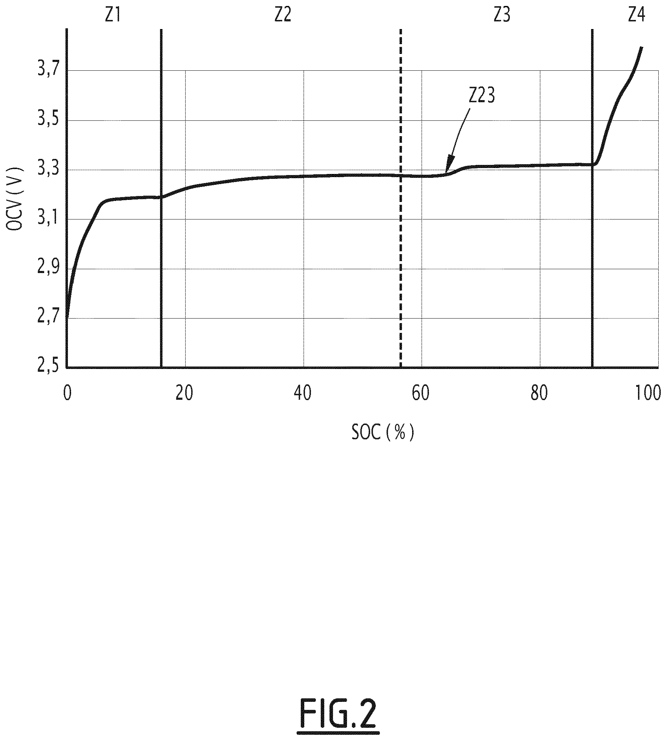

L'élément électrochimique 12 présente une caractéristique état de charge SOC - tension en circuit ouvert OCV telle que visible sur la figure 2. Cette caractéristique est notée caractéristique SOC/OCV dans la suite.

Dans la figure 2, l'état de charge SOC est exprimé en pourcentage d'un état de charge maximale.

La caractéristique SOC/OCV présente quatre zones, une première zone Z1, une deuxième zone Z2, une troisième zone Z3 et une quatrième zone Z4.

La première zone Z1 correspond au début de la charge et la quatrième zone Z4 à la fin de la charge.

Pour les deux zones intermédiaires, dans la mesure où les deuxième zone Z2 et troisième zone Z3 correspondent à une portion plane, il sera utilisé la dénomination portion plane (Z23) dans la suite.

La portion plane Z23 est une portion dans laquelle la variation de tension en circuit ouvert OCV est inférieure à 30 mV pour une variation d'au moins 10% de l'état de charge SOC.

Un tel type de caractéristique SOC/OCV se retrouve notamment lorsque l'élément électrochimique 12 est un élément électrochimique comprenant un matériau actif cathodique choisi dans les groupes suivants ou leurs mélanges :

i) un composé de formule $Li_xFe_{1-y}M_yPO_4$ (LFMP) où M est choisi dans le groupe consistant en B, Mg, Al, Si, Ca, Ti, V, Cr, Mn, Co, Ni, Cu, Zn, Y, Zr, Nb et Mo; et $0,8 \leq x \leq 1,2$ ; $0 \leq y \leq 0,6$,

ii) un composé de formule $Li_xMn_{1-y-z}M'_yM''_zPO_4$ (LMP), où M' et M'' sont différents l'un de l'autre et sont choisis dans le groupe consistant en B, Mg, Al, Si, Ca, Ti, V, Cr, Fe, Co, Ni, Cu, Zn, Y, Zr, Nb et Mo, avec $0,8 \leq x \leq 1,2$ ; $0 \leq y \leq 0,6$ ; $0,0 \leq z \leq 0,2$,

iii) un composé de formule $Li_xMn_{2-y-z}Ni_yM_zO_{4-d-c}F_c$ (LMNO) où M représente un ou plusieurs éléments choisis dans le groupe consistant en B, Mg, Al, Si, Ca, Ti, V, Cr, Fe, Co, Cu, Zn, Y, Zr, Nb, Ru, W et Mo;.

et $1 \leq x \leq 1,4$ ; $0 < y \leq 0,6$ ; $0 \leq z \leq 0,2$ ; $0 \leq d \leq 1$ ; $0 \leq c \leq 1$,

iv) un composé de formule $Li_xMn_{2-y-z}M'_yM''_zO_4$ (LMO), où M' et M" sont choisis dans le groupe consistant en B, Mg, Al, Si, Ca, Ti, V, Cr, Fe, Co, Ni, Cu, Zn, Y, Zr, Nb et Mo ;. M' et M" étant différents l'un de l'autre, et $1 \leq x \leq 1,4$ ; $0 \leq y \leq 0,6$ ; $0 \leq z \leq 0,2$, et

v) un composé de formule $LiVPO_4F$ (LVPF).

La matière active anodique n'est pas particulièrement limitée. Elle est un matériau capable d'insérer du lithium dans sa structure. Elle peut être choisie parmi des composés du lithium, des matériaux carbonés comme le graphite, le coke, le noir de carbone et le carbone vitreux. Elle peut aussi être à base d'étain, de silicium, de composés à base de carbone et de silicium, de composés à base de carbone et d'étain ou de composés à base de carbone, d'étain et de silicium. Elle peut aussi être un oxyde de titane lithié tel que $Li_4Ti_5O_{12}$ ou un oxyde de titane de de niobium tel que $TiNb_2O_7$.

Le système de gestion 14 est un système propre à gérer l'élément électrochimique 12.

Le système de gestion 14 comporte un capteur de tension 16, un capteur de courant 18, un capteur de la température 20 et un calculateur 22.

Le capteur de tension 16 est propre à mesurer la tension aux bornes de l'élément électrochimique 12.

Le capteur de courant 18 est propre à mesurer le courant aux bornes de l'élément électrochimique 12.

Le capteur de température 20 est propre à mesurer la température aux bornes de l'élément électrochimique 12.

Le calculateur 22 est propre à mettre en œuvre un procédé d'estimation de l'état de charge de l'élément électrochimique 12.

Le calculateur 22 est un circuit électronique conçu pour manipuler et/ou transformer des données représentées par des quantités électroniques ou physiques dans des registres du calculateur et/ou des mémoires en d'autres données similaires correspondant à des données physiques dans les mémoires de registres ou d'autres types de dispositifs d'affichage, de dispositifs de transmission ou de dispositifs de mémorisation.

En tant qu'exemples spécifiques, le calculateur 22 comprend un processeur monocœur ou multicœurs (tel qu'une unité de traitement centrale (CPU), une unité de traitement graphique (GPU), un microcontrôleur et un processeur de signal numérique (DSP)), un circuit logique programmable, comme un circuit intégré spécifique à une application (ASIC), un réseau de portes programmables *in situ* (FPGA), un dispositif logique programmable (PLD) et des réseaux logiques programmables (PLA), une machine à états, une porte logique et des composants matériels discrets.

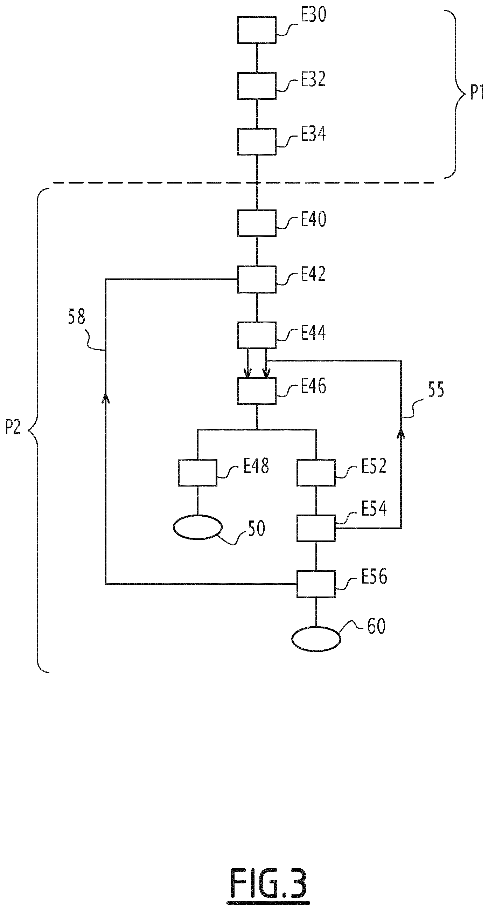

Un exemple de mise en œuvre du procédé d'estimation de l'état de charge SOC est maintenant décrit en référence à l'ordinogramme de la figure 3.

Le procédé d'estimation de l'état de charge SOC comporte deux phases, une phase d'apprentissage P1 et une phase d'utilisation P2.

Selon l'exemple décrit, la phase d'apprentissage P1 est mise en œuvre hors-ligne, c'est-à-dire que la phase d'apprentissage n'est pas embarquée.

La phase d'apprentissage P1 comporte une étape d'apprentissage E30 d'un réseau de neurones, une étape de calcul E32 et une étape d'établissement E34.

Lors de l'étape d'apprentissage E30, le réseau de neurones est entraîné pour estimer l'état de charge SOC de l'élément électrochimique 12 à partir des valeurs de tension de l'élément électrochimique 12, de courant de l'élément électrochimique 12, de température de l'élément électrochimique 12 et de capacité C de l'élément électrochimique 12.

Les valeurs de tension, du courant et de température proviennent respectivement du capteur de tension 16, du capteur de courant 18 et du capteur de température 20.

Selon l'exemple décrit, ces valeurs sont mesurées régulièrement.

La valeur de capacité C est obtenue moins fréquemment et peut être obtenue par toute technique notamment par détermination lors d'une charge ou une décharge complète.

Le réseau de neurones à apprendre est un perceptron multicouche.

Un tel réseau de neurones est plus souvent désigné par l'abréviation MLP qui renvoie à la dénomination anglaise correspondante de « multilayer perceptron ».

Ainsi, un réseau de neurones est une succession ordonnée de couches de neurones dont chacune prend ses entrées sur les sorties de la couche précédente.

Plus précisément, chaque couche comprend des neurones prenant leurs entrées sur les sorties des neurones de la couche précédente.

Dans l'exemple, les couches sont denses, c'est-à-dire qu'un neurone d'une couche prend les entrées de l'ensemble des neurones de la couche précédente. L'expression anglaise de « fully connected » est parfois utilisée pour désigner ce type de couches.

Chaque couche est reliée par une pluralité de synapses. Un poids synaptique est associé à chaque synapse. C'est le plus souvent un nombre réel pouvant prendre des valeurs positives comme négatives.

Chaque neurone est propre à effectuer une somme pondérée des valeur(s) reçue(s) de la part des neurones de la couche précédente, chaque valeur étant alors multipliée par le poids synaptique respectif, puis à appliquer une fonction d'activation, typiquement une fonction non-linéaire, à ladite somme pondérée, et à délivrer aux neurones de la couche suivante la valeur résultat de l'application de la fonction d'activation. La fonction d'activation permet d'introduire une non-linéarité dans le traitement effectué par chaque neurone. La fonction sigmoïde, la fonction tangente hyperbolique, la fonction de Heaviside sont des exemples de fonctions d'activation.

Le réseau de neurones à apprendre est un réseau de neurones facilement embarquable.

Aussi, il convient que le réseau de neurones présente un nombre de neurones limités.

Par exemple, le nombre total du réseau de neurones est de l'ordre d'une centaine de neurones, de préférence 100 neurones.

Dans l'exemple décrit, le réseau de neurones comprend plusieurs couches, à savoir une couche d'entrée, une couche cachée et une ou plusieurs couche(s) de sortie.

Le réseau de neurones est appris par utilisation d'une technique d'apprentissage supervisée.

Ainsi, il s'agit d'apprendre les paramètres libres du réseau de neurones à partir d'un jeu de données obtenu par des expériences réelles en laboratoire, typiquement pour plus de 100 éléments électrochimiques 12 différents.

Durant ces expériences, des éléments électrochimiques 12 subissent des cycles successifs et les valeurs électriques de ces éléments électrochimiques 12 (courant, tensions, état de charge SOC, capacité) et les valeurs de température sont relevées pour former le jeu de données.

Le jeu de données est ensuite séparé en jeu d'entraînement et jeu de test, selon par exemple une proportion de 80%-20%.

Le jeu d'entraînement est utilisé pour que le réseau de neurone apprenne ses différents paramètres libres par itérations successives jusqu'à vérifier un critère de performance souhaitée. Il est ainsi obtenu un réseau de neurones appris.

Le jeu de test sert ensuite à évaluer la performance du réseau de neurones appris.

Le réseau de neurones constitue ainsi, pour l'élément électrochimique 12, un premier modèle M1 estimant une valeur de l'état de charge SOC à partir des valeurs de tension, de courant, de température et de capacité.

Le premier modèle M1 est plutôt robuste aux biais de courant même forts, de par sa structure basée sur un perceptron multicouche qui est sans effet mémoire, c'est-à-dire qui utilise uniquement les valeurs courantes et non les valeurs antérieures pour obtenir l'estimation souhaitée.

En outre, du fait de sa faible dimension, le premier modèle M1 est facilement embarquable car son empreinte mémoire et son empreinte processeur sont réduites.

Néanmoins, cela entraîne qu'un tel premier modèle M1 présente une erreur d'estimation, c'est-à-dire un écart entre la valeur estimée et la valeur réelle, relativement importante dans certaines conditions.

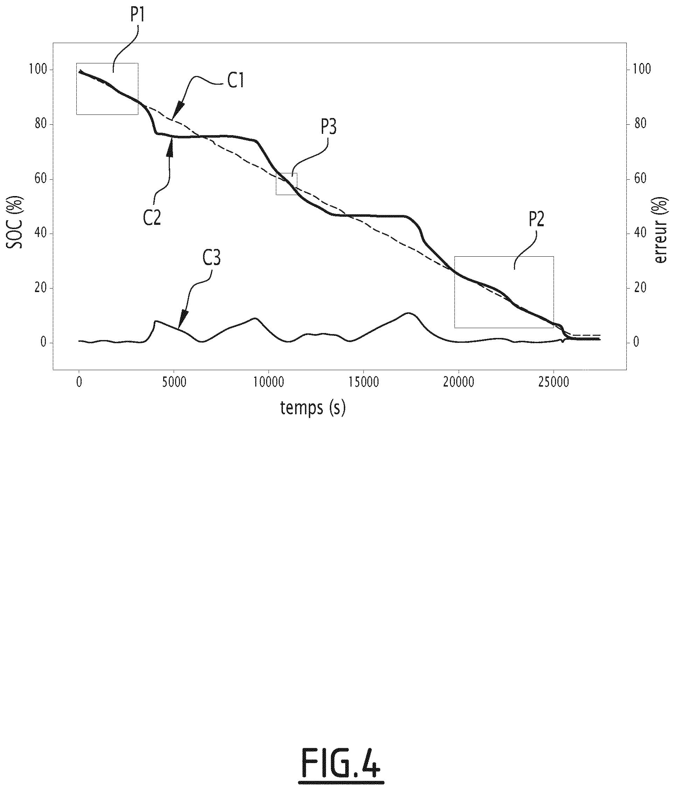

La figure 4 illustre graphiquement les performances obtenues expérimentalement en utilisant le premier modèle M1 en l'absence de biais de courant.

Sur la figure 4, la première courbe C1 correspond à la valeur réelle de l'état de charge SOC, la deuxième courbe C2 correspond à la valeur estimée par le premier modèle M1 et la troisième courbe C3 à l'erreur d'estimation.

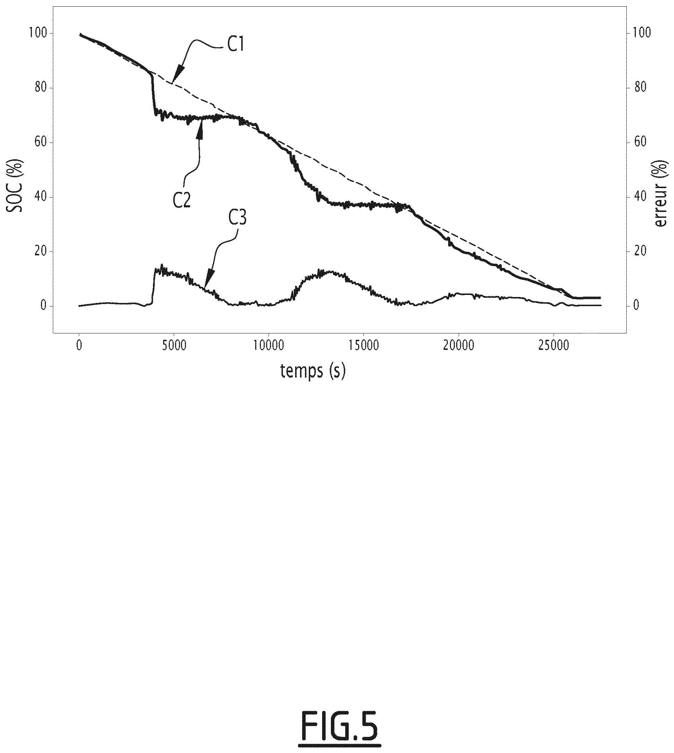

L'estimation est imparfaite sauf dans les trois portions encadrées sur la figure 4. Ces portions correspondent à la première zone Z1, à la quatrième zone Z4 et à la jonction entre la deuxième zone Z2 et la troisième zone Z3. Par ailleurs, la robustesse aux biais de courant apparaît en comparant la figure 4 à la figure 5 qui correspond aux performances du premier modèle M1 en présence d'un biais de courant. L'erreur observée est très peu augmentée.

Lors de l'étape de calcul E32, l'erreur statistique d'estimation est calculée sous forme d'une première table TAB1.

Pour cela, il est calculé la différence entre la valeur estimée par le premier modèle M1 et la valeur réelle de l'état de charge SOC pour chaque élément du jeu de données d'entraînement.

Pour limiter l'espace de mémorisation alloué à la première table TAB1, les valeurs d'état de charge SOC sont regroupées selon une tranche prédéfinie.

En l'occurrence, la tranche est une valeur de 1%. Cela signifie que tous les états de charge SOC égaux à 1% près sont considérés comme un même état de charge SOC. Cela revient à considérer une précision pour la mesure de l'état de charge SOC de l'ordre de 1%.

Il est ainsi obtenu pour chaque valeur réelle de l'état de charge SOC un ensemble de plusieurs erreurs, une erreur pour chaque élément du jeu de données présentant la même valeur de l'état de charge SOC.

Il est alors calculé la moyenne des erreurs associées à une valeur réelle de l'état de charge SOC pour obtenir l'erreur statistique associée à la valeur réelle de l'état de charge SOC. La moyenne calculée est, selon l'exemple proposé, une moyenne arithmétique.

La première table TAB1 associe alors à chaque valeur réelle de l'état de charge SOC l'erreur statistique d'estimation du premier modèle M1.

L'erreur statistique est alors l'écart moyen avec la valeur estimée.

Lorsque l'erreur statistique est positive, cela signifie que la valeur estimée est surestimée tandis que pour une erreur statistique négative, la valeur estimée est sous-estimée.

A titre de remarque, il peut être noté que le formalisme tabulaire précédent peut être vu sous le formalisme d'une fonction de correction correspondant à une interpolation des valeurs de la table.

Ce changement de formalisme permet d'obtenir exactement les mêmes résultats qu'avec ceux obtenus avec la première table TAB1, formalisme qui sera utilisé dans la suite.

Une telle première table TAB1 peut être utilisée pour obtenir un deuxième modèle M2 obtenu en corrigeant le premier modèle M1 avec la première table TAB1.

Un tel modèle est parfois qualifié de modèle autocorrigé. Cette autocorrection est rendue possible par le fait que la première table TAB1 est peu sensible aux données d'entrées pourvu que le première modèle M1 lui soit fourni.

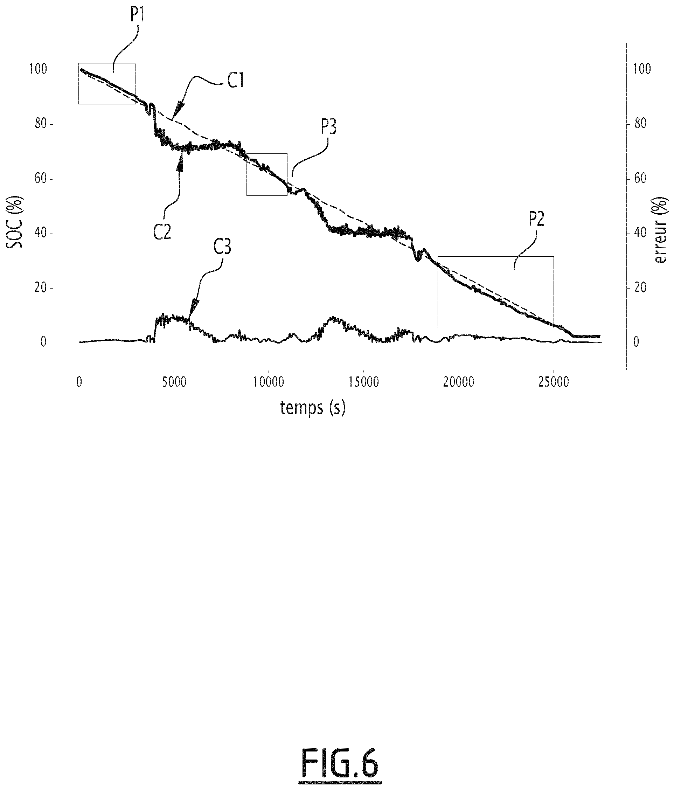

La performance obtenue par un tel deuxième modèle M2 est représentée sur la figure 6 avec les mêmes conventions que pour la figure 4.

La comparaison de cette figure 6 avec la figure 4 montre que la deuxième portion P2 et la troisième portion P3 sont plus larges, ce qui permet d'obtenir trois portions permettant d'effectuer une recalibration comme cela sera décrit ultérieurement.

Lors de l'étape d'établissement E34, il est établi une deuxième table TAB2 portant sur le modèle obtenu en corrigeant le première modèle M1 avec la première table TAB1, c'est-à-dire le deuxième modèle M2.

A partir des valeurs d'état de charge SOC obtenues par le modèle autocorrigé, il est possible d'établir la deuxième table TAB2 en indiquant une mention « fiable » et « non fiable » selon un seuil pour l'erreur statistique correspondant au deuxième modèle M2.

Ainsi, par exemple, si l'erreur statistique du deuxième modèle M2 est supérieure au seuil, la valeur d'état de charge SOC n'est pas fiable et réciproquement, si l'erreur statistique du deuxième modèle M2 est inférieure ou égale au seuil, la valeur d'état de charge SOC est fiable.

Par exemple, le seuil est fixé en fonction de la précision voulue pour le modèle.

Le réseau de neurones et les deux tables TAB1 et TAB2 sont chargées sur une mémoire du calculateur 22.

Le calculateur 22 est ainsi prêt pour mettre en œuvre la phase d'utilisation.

Au contraire de la phase d'apprentissage P1 qui est effectuée une seule fois, la phase d'utilisation P2 est mise en œuvre pour une pluralité d'instants.

En particulier, la phase d'utilisation P2 correspond à une phase d'utilisation en temps réel de la batterie 10.

Par exemple, les instants sont équirépartis, par exemple espacés d'un intervalle de temps compris entre 100 millisecondes (ms) et 2 secondes (s).

Les étapes de la phase d'utilisation P2 sont mises en œuvre pour chaque instant.

En ce sens, il peut ainsi être considéré que la phase d'utilisation P2 est itérative et qu'à chaque instant de mise en œuvre, une itération a lieu.

Selon l'exemple décrit, la phase d'utilisation P2 est mise en œuvre en ligne, c'est-à-dire que la phase d'utilisation P2 est embarquée et donc mise en œuvre par le calculateur 22.

En outre, comme visible à la figure 3, la phase d'utilisation P2 comporte une étape d'obtention E40, une étape de correction E42, une étape de calcul E44, une étape de détermination, E46 une étape de sélection E48 ou E52 et éventuellement une autre étape de correction E54 et de détermination E56.

Lors de l'étape d'obtention E40, le calculateur 22 obtient des mesures (valeurs) de la tension V, du courant I de la température T et la capacité C de l'élément électrochimique 12.

Lors de l'étape de correction E42, le calculateur 22 soustrait le biais de mesure de courant à la valeur du courant I obtenue.

Le biais de mesure de courant provient notamment du biais de mesure intrinsèque au capteur de courant 18 et de sa précision variable en fonction de l'amplitude du courant à mesurer.

Le calculateur 22 obtient ainsi une valeur de courant I corrigée.

Lorsque le biais de mesure n'est pas connu, il est considéré que le biais est nul.

Lors de l'étape de calcul E44, le calculateur 22 calcule la valeur de l'état de charge SOC selon deux techniques distinctes, comme illustré schématiquement sur la figure 3 par deux flèches vers l'étape de détermination E46.

Selon une première technique, le calculateur 22 applique le premier modèle M1 sur la valeur de tension V obtenue, la valeur de courant I corrigée, la valeur de température T et la valeur de la capacité C obtenues lors de l'étape d'obtention E40.

Cela revient à réaliser une inférence grâce au réseau de neurones appris hors ligne pour obtenir une valeur de l'état de charge SOC sans autocorrection.

Le calculateur 22 obtient ainsi une valeur de l'état de charge SOC estimée.

Le calculateur 22 applique ensuite la correction de la première table TAB1 sur la valeur de l'état de charge SOC estimée.

Pour cela, le calculateur 22 vient lire la valeur de l'erreur correspondant à la tranche à laquelle appartient la valeur de l'état de charge SOC estimée et soustrait cette valeur lue à la valeur estimée.

Il est ainsi obtenu une valeur de l'état de charge SOC corrigée qui correspond à la valeur de l'état de charge SOC obtenue selon la première technique notée $SOC_{TECH1}$.

Du fait de l'emploi simultanée du premier modèle M1 et de la première table TAB1, la première technique correspond à l'emploi d'un réseau de neurones autocorrigé.

Selon une deuxième technique, le calculateur 22 réalise la technique dite coulométrique présentée précédemment. Une telle technique correspond à un deuxième modèle M2.

Cette technique repose sur le fait que l'état de charge SOC d'un élément électrochimique 12 dépend directement du ratio entre la quantité de charge accumulée (ou comptage des Ampères-heures en référence à l'unité souvent utilisée pour cette quantité) et la capacité de l'élément électrochimique 12.

Ainsi, le calculateur 22 utilise alors les valeurs de courant et la valeur de la capacité selon la formule suivante :

$$SOC = SOC_0 + \frac{\int_0^t I \times dt}{c}$$

Plus précisément, le calculateur 22 détient en mémoire une valeur de la quantité de charge accumulée à l'itération précédente $Ah_{précédente}$, vient ajouter à cette valeur le résultat de l'intégration temporelle de la valeur corrigée du courant sur l'intervalle de temps écoulé depuis l'itération précédente. La valeur ainsi obtenue est la valeur de la quantité de charge accumulée à l'itération courante $Ah_{courante}$, valeur qui est mémorisée par le calculateur 22.

La calculateur 22 effectue ensuite la division par la valeur de la capacité et obtient ainsi une valeur de l'état de charge SOC selon la deuxième technique $SOC_{TECH2}$.

A l'issue de l'étape de calcul, le calculateur 22 dispose ainsi de deux valeurs distinctes de l'état de charge SOC de l'élément électrochimique 12, à savoir $SOC_{TECH1}$ et $SOC_{TECH2}$.

Selon l'exemple décrit, lors de l'étape de détermination E46, le calculateur 22 détermine si la valeur de l'état de charge selon la première technique $SOC_{TECH1}$ est une valeur fiable.

Selon l'exemple décrit, le calculateur 22 utilise la deuxième table TAB2.

La deuxième table TAB2 sert ainsi à déterminer si la valeur de l'état de charge selon la première technique $SOC_{TECH1}$ est dans un intervalle de confiance.

A l'issue de l'étape de détermination E46, le calculateur 22 a déterminé que la valeur de l'état de charge selon la première technique $SOC_{TECH1}$ est soit non fiable soit fiable.

Dans le cas où la valeur de l'état de charge selon la première technique $SOC_{TECH1}$ est non fiable, cela signifie que la valeur de l'état de charge selon la deuxième technique $SOC_{TECH2}$ est plus fiable que la valeur de l'état de charge selon la première technique $SOC_{TECH1}$.

Le calculateur 22 considère alors que la valeur de l'état de charge SOC estimée est égale à la valeur de l'état de charge selon la deuxième technique $SOC_{TECH2}$ et sélectionne, lors de l'étape de sélection E48, la valeur de l'état de charge selon la deuxième technique $SOC_{TECH2}$ comme la valeur estimée finale de l'état de charge SOC, c'est-à-dire la valeur de sortie du procédé d'estimation.

Cette sortie de la valeur estimée finale de l'état de charge SOC est illustrée schématiquement par l'élément 50 sur la figure 1. La valeur estimée finale est, par exemple, affichée sur un dispositif d'affichage.

A contrario, dans le cas où la valeur de l'état de charge selon la première technique $SOC_{TECH1}$ est fiable, cela signifie que la valeur de l'état de charge selon la première technique $SOC_{TECH1}$ est plus fiable que valeur de l'état de charge selon la deuxième technique $SOC_{TECH2}$.

Le calculateur 22 considère alors que la valeur de l'état de charge SOC mesurée est égale à la valeur de l'état de charge selon la première technique $SOC_{TECH1}$ et sélectionne lors de l'étape de sélection E52, la valeur de l'état de charge selon la première technique $SOC_{TECH1}$ comme la valeur estimée finale de l'état de charge SOC, c'est-à-dire la valeur de sortie du procédé d'estimation.

Le calculateur 22 met alors en œuvre l'étape de correction E54.

Le calculateur 22 calcule alors une valeur de quantité de charge accumulée correspondant à la valeur de l'état de charge selon la première technique $SOC_{TECH1}$ en utilisant la valeur de la capacité C.

Le calculateur 22 corrige alors le deuxième modèle M2 en modifiant la valeur de la quantité de charge accumulée à l'itération courante $Ah_{courante}$ qui devient la valeur déduite précédemment à l'aide de la première technique.

Cela peut être interprété que, dans ce cas, le compteur d'ampères-heures est réinitialisé à la valeur pouvant être déduite à l'aide du premier modèle autocorrigé.

L'étape de correction E54 qui vient d'être décrite correspond à une étape de recalibration du deuxième modèle M2.

Cette recalibration est schématiquement illustrée par la flèche 55 sur la figure 3.

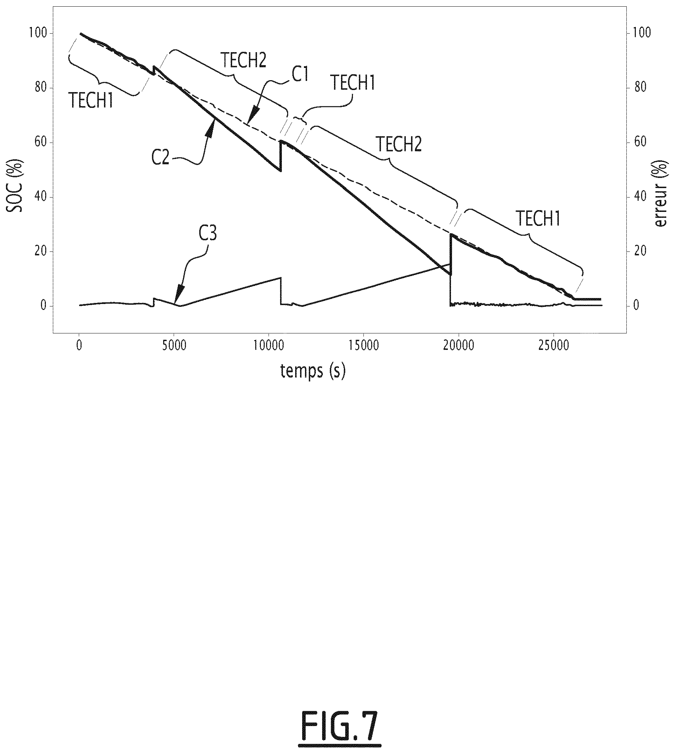

La figure 7 est une figure expérimentale montrant bien l'intérêt de cette recalibration pour le cas où le biais de courant est de -2A.

Sur la figure 7, la première courbe C1 correspond à la valeur de l'état de charge réelle de l'état de charge SOC, la deuxième courbe C2 correspond à la valeur estimée finale de l'état de charge, la troisième courbe C3 à l'erreur d'estimation.

Lorsque la valeur estimée finale provient de la première technique, une accolade délimitant la portion associée à la mention TECH1 est présente dans la figure 7 et réciproquement, lorsque la valeur estimée finale provient de la deuxième technique, une accolade délimitant la portion associée à la mention TECH2 est présente dans la figure 7.

Les portions pour laquelle la valeur estimée finale provient de la première technique sont les mêmes que précédemment (première zone Z1, la quatrième zone Z4 et jonction entre la deuxième zone Z2 et la troisième zone Z3).

Les portions pour laquelle la valeur estimée finale provient de la deuxième technique correspondent respectivement au reste de la deuxième Z2 et au reste de la troisième Z3.

Dans ces portions, la valeur estimée finale s'éloigne progressivement de la valeur réelle de l'état de charge SOC jusqu'à ce qu'elle atteigne un écart tel que la valeur obtenue par la première technique devient plus fiable. Il est alors possible de corriger l'écart $\Delta SOC$ qui est

représenté sur la figure 7. Cela correspond à la recalibration et permet de limiter l'erreur.

Lorsqu'à l'itération précédente la valeur selon la première technique SOC$_{TECH1}$ n'était pas fiable, le calculateur 22 détermine, lors de l'étape de détermination E56, le biais de mesure de courant.

Le biais de mesure du courant se déduit par utilisation de la différence d'état de charge entre les deux techniques depuis le dernier instant pour lequel la première valeur calculée de l'état de charge avait été déterminée comme non fiable.

Il vient ainsi que le biais de mesure du courant peut être calculé par la formule suivante :

$$I_{biais} = C * \frac{SOC_{T2}(t) - SOC_{T1}(t)}{\Delta t}$$

Dans la formule précédente, $I_{biais}$ désigne le biais de mesure et $\Delta t$ le temps écoulé depuis le début de l'intervalle de temps durant lequel c'est la deuxième technique SOC$_{TECH2}$ qui est utilisée.

Cette valeur de biais de mesure ainsi déterminée est mémorisée par le calculateur 22 pour être utilisée lors de la mise en œuvre de l'étape de correction de l'itération suivante, comme l'illustre la flèche 58 sur la figure 3.

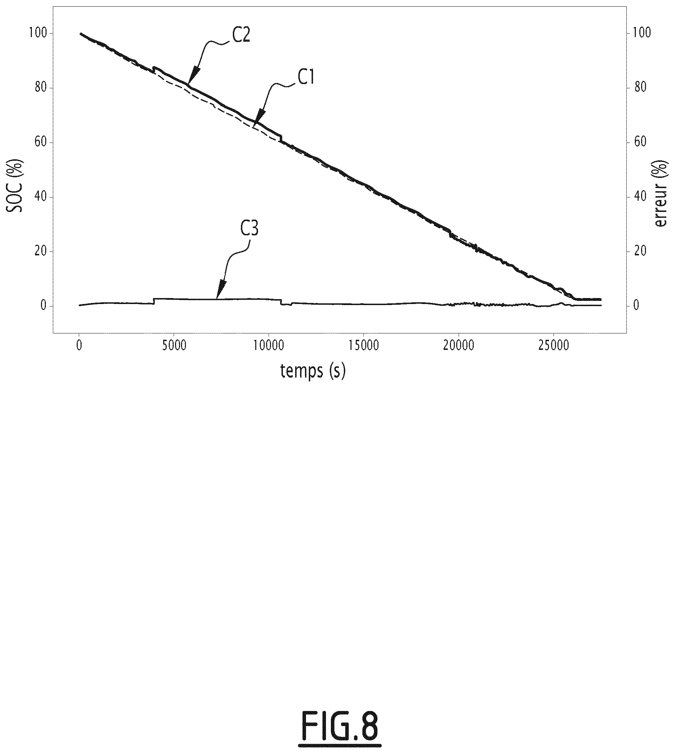

L'intérêt de corriger le courant de biais apparaît bien avec la figure 8 qui correspond aux mêmes conditions expérimentales que celles de la figure 7 sauf que le biais de mesure est corrigé

La diminution de l'erreur obtenue est manifeste.

La sortie de la valeur estimée de l'état de charge SOC est illustrée schématiquement par l'élément 60 sur la figure 1. La valeur estimée est, par exemple, affichée sur un dispositif d'affichage.

Dans chacun des cas, la valeur estimée est donc la valeur la plus fiable.

Un tel procédé permet donc d'estimer la valeur de l'état de charge SOC de l'élément électrochimique 12 avec une meilleure précision.

En effet, le procédé correspond à l'utilisation d'un modèle hybride utilisant deux techniques distinctes : une première technique issue du monde de l'apprentissage machine basée sur l'application d'un réseau de neurones autocorrigé et une deuxième technique issue du monde de la mesure et basée sur un comptage coulométrique.

Ce modèle hybride est capable de sélectionner la meilleure des deux valeurs.

Il convient de noter que ce gain en précision est obtenu avec un surcoût calculatoire relativement faible par rapport à l'emploi de la deuxième technique seule car le réseau de neurones utilisé présente une empreinte mémoire très restreinte (peu de neurones). Cela entraîne que le gain en précision reste compatible avec une application embarquée.

Par ailleurs, le procédé permet également d'effectuer une recalibration de la deuxième technique alors que l'élément électrochimique 12 est en utilisation usuelle, même dans la portion plane Z23. Cela permet ainsi à l'élément électrochimique 12 de continuer sa mission tout en ayant une bonne estimation de l'état de la charge SOC. Ceci a pour conséquence une meilleure disponibilité de l'élément électrochimique 12 et/ou d'éviter le surdimensionnement de la batterie 10.

Enfin, grâce notamment au choix d'un réseau de neurones qui estime uniquement sur la base des valeurs actuelles sans effet de mémoire, la première technique est relativement robuste au biais de courant. Cela permet de compenser la déviation engendrée par un biais de courant, résultant en une précision accrue.

Il peut aussi être noté que le profil de l'erreur statistique est répétable quel que soit les types de sollicitation utilisés, ce qui était inattendu. Le profil d'erreur statistique est certes lié à la chimie de l'élément électrochimique 12 mais invariant selon la sollicitation ce qui rend le procédé plus apte à être utilisé dans une grande variété d'applications possibles.

D'autres modes de réalisation bénéficiant des avantages précités sont également envisageables.

En particulier, il est possible de calculer la valeur de l'état de charge SOC de l'élément électrochimique 12 selon une seule technique pour diminuer la charge calculatoire.

Dans un tel cas, il est déterminé la technique la plus fiable parmi la première technique et la deuxième technique en fonction d'un critère de fiabilité dépendant de la valeur de la fonction de la correction pour la valeur calculée de l'état de charge SOC et uniquement lorsque la technique déterminée comme fiable n'est pas celle qui a fait l'objet du calcul, celle-ci est calculée.

Cela permet d'éviter de calculer à chaque instant deux valeurs, sachant qu'une des deux ne sera pas utilisée.

Il peut même être envisagé un système de basculement, c'est-à-dire que la technique selon laquelle la valeur de l'état de charge SOC de l'élément électrochimique 12 est calculée à l'instant t est la technique qui a été déterminée comme fiable à l'instant précédent.

Cela permet également de diminuer le nombre de fois où un calcul de valeur d'état de charge SOC est effectué après l'étape de détermination E46 parce que la technique déterminée est différente de la technique choisie pour effectuer le calcul lors de l'étape de calcul E44.

**Revendications**

1. Procédé d'estimation de l'état de charge (SOC) d'au moins un élément électrochimique (12) d'une batterie (10),

   le procédé étant mis en œuvre par un calculateur (22), le calculateur (22) mémorisant un premier modèle (M1) donnant à partir d'une valeur de tension, d'une valeur de courant, d'une valeur de température et d'une valeur de capacité de l'au moins un élément électrochimique (12) la valeur de l'état de charge (SOC) de l'au moins un élément électrochimique (12), le premier modèle (M1) étant un réseau de neurones appris, le calculateur (22) mémorisant une fonction de correction donnant pour chaque valeur de l'état de charge (SOC) l'erreur statistique d'estimation par le premier modèle (M1), le procédé comprenant, pour plusieurs instants, les étapes de :

- obtention de valeurs de la tension, du courant, de la température et de la capacité de l'au moins un élément électrochimique (12),
- calcul de la valeur de l'état de charge (SOC) de l'au moins un élément électrochimique (12) selon une première technique et une deuxième technique,

la première technique comportant les opérations suivantes :

- application du premier modèle sur la valeur de la tension, du courant, de la température et de la capacité de l'au moins un élément électrochimique (12) au même instant, pour obtenir une valeur d'état de charge (SOC) estimée, et
- application de la fonction de correction sur la valeur d'état de charge estimée, pour obtenir une première valeur calculée de l'état de charge (SOC),

la deuxième technique comportant les opérations suivantes :

- calcul de la valeur de la quantité de charge accumulée par utilisation des valeurs du courant obtenues,
- déduction d'une deuxième valeur calculée de l'état de charge (SOC) par calcul du ratio de la valeur de la quantité de charge accumulée et de la capacité de l'au moins un élément électrochimique (12),

- détermination de la technique la plus fiable parmi la première technique et la deuxième technique en fonction d'un critère de fiabilité dépendant de la valeur de l'erreur statistique d'estimation d'un deuxième modèle (M2) correspondant au premier modèle (M1) corrigé par la fonction de correction pour la première valeur calculée de l'état de charge (SOC),
- calcul de la valeur calculée de l'état de charge (SOC) selon la technique déterminée comme fiable si la valeur n'a pas été calculée précédemment, et
- sélection de la valeur calculée de l'état de charge (SOC) selon la technique déterminée comme étant la valeur estimée de l'état de charge (SOC).

2. Procédé d'estimation selon la revendication 1, dans lequel le procédé comporte, également, une étape de correction de la quantité de charge accumulée calculée utilisée par la deuxième technique pour que le calcul de la deuxième technique conduise à obtenir la première valeur calculée de l'état de charge (SOC) lorsque la première technique est déterminée comme fiable

3. Procédé d'estimation selon la revendication 1 ou 2, dans lequel le procédé comporte, en outre, une étape de correction de la valeur du courant obtenue par soustraction du biais de mesure du courant, pour obtenir une valeur corrigée du courant, les étapes de calcul étant appliquées sur la valeur corrigée du courant.

4. Procédé d'estimation selon la revendication 3, dans lequel le procédé comporte, en outre, lorsque la première technique est déterminée comme fiable à un instant après un intervalle de temps durant lequel la deuxième technique a été déterminée comme fiable à chaque instant de l'intervalle de temps, une étape de détermination du biais de mesure du courant par utilisation de la différence d'état de charge entre les deux techniques depuis le début de l'intervalle de temps.

5. Procédé d'estimation selon l'une quelconque des revendications 1 à 4, dans lequel le réseau de neurones du premier modèle (M1) est un perceptron multicouche.

6. Procédé d'estimation selon l'une quelconque des revendications 1 à 5, dans lequel le réseau de neurones du premier modèle (M1) comporte un nombre de neurones inférieur ou égal à 100.

7. Procédé d'estimation selon l'une quelconque des revendications 1 à 6, dans lequel l'au moins un élément électrochimique (12) présentant une caractéristique état de charge (SOC) - tension en circuit ouvert (OCV) avec une portion plane, une portion plane étant une portion dans laquelle la variation de tension en circuit ouvert (OCV) est inférieure à 30 mV pour une variation d'au moins 10% de l'état de charge (SOC).

8. Procédé d'estimation selon l'une quelconque des revendications 1 à 7, dans lequel l'au moins un élément électrochimique (12) comprend un matériau actif cathodique choisi dans les groupes suivants ou leurs mélanges :

    i) un composé de formule $Li_xFe_{1-y}M_yPO_4$ (LFMP) où M est choisi dans le groupe consistant en B, Mg, Al, Si, Ca, Ti, V, Cr, Mn, Co, Ni, Cu, Zn, Y, Zr, Nb et Mo ; et $0,8 \leq x \leq 1,2$ ; $0 \leq y \leq 0,6$,
    ii) un composé de formule $Li_xMn_{1-y-z}M'_yM''_zPO_4$ (LMP), où M' et M" sont différents l'un de l'autre et sont choisis dans le groupe consistant en B, Mg, Al, Si, Ca, Ti, V, Cr, Fe, Co, Ni, Cu, Zn, Y, Zr, Nb et Mo, avec $0,8 \leq x \leq 1,2$ ; $0 \leq y \leq 0,6$ ; $0,0 \leq z \leq 0,2$,
    iii) un composé de formule $Li_xMn_{2-y-z}Ni_yM_zO_{4-d-c}F_c$ (LMNO) où M représente un ou plusieurs éléments choisis dans le groupe consistant en B, Mg, Al, Si, Ca, Ti, V, Cr, Fe, Co, Cu, Zn, Y, Zr, Nb, Ru, W et Mo;. et $1 \leq x \leq 1,4$ ; $0 < y \leq 0,6$ ; $0 \leq z \leq 0,2$ ; $0 \leq d \leq 1$ ; $0 \leq c \leq 1$,
    iv) un composé de formule $Li_xMn_{2-y-z}M'_yM''_zO_4$ (LMO), où M' et M" sont choisis dans le groupe consistant en B, Mg, Al, Si, Ca, Ti, V, Cr, Fe, Co, Ni, Cu, Zn, Y, Zr, Nb et Mo ;. M' et M" étant différents l'un de l'autre, et $1 \leq x \leq 1,4$ ; $0 \leq y \leq 0,6$ ; $0 \leq z \leq 0,2$, et
    v) un composé de formule $LiVPO_4F$ (LVPF).

9. Calculateur (22) propre à estimer l'état de charge (SOC) d'au moins un élément électrochimique (12) d'une batterie (10),

    le calculateur (22) mémorisant un premier modèle (M1) donnant à partir d'une valeur de tension, d'une valeur de courant, d'une valeur de température et d'une valeur de capacité de l'au moins un élément électrochimique (12) la valeur de l'état de charge (SOC) de l'au moins un élément électrochimique (12), le premier modèle (M1) étant un réseau de neurones appris, le calculateur (22) mémorisant une fonction de correction donnant pour chaque valeur de l'état de charge (SOC) l'erreur statistique d'estimation par le premier modèle (M1), le calculateur (22) étant, pour plusieurs instants, propre à:

    - obtenir des valeurs de la tension, du courant, de la température et de la capacité de l'au moins un élément électrochimique (12),
    - calculer la valeur de l'état de charge (SOC) de l'au moins un élément électrochimique (12) selon une première technique et une deuxième technique,

la première technique comportant les opérations suivantes :

    - application du premier modèle sur la valeur de la tension, du courant, de la température et de la capacité de l'au moins un élément électrochimique (12) au même instant, pour obtenir une valeur d'état de charge (SOC) estimée, et
    - application de la fonction de correction sur la valeur d'état de charge estimée, pour obtenir une première valeur calculée de l'état de charge (SOC),

la deuxième technique comportant les opérations suivantes :

    - calcul de la valeur de la quantité de charge accumulée par utilisation des valeurs du courant obtenues,
    - déduction d'une deuxième valeur calculée de l'état de charge (SOC) par calcul du ratio de la valeur de la quantité de charge accumulée et de la capacité de l'au moins un élément électrochimique (12),

    - déterminer la technique la plus fiable parmi la première technique et la deuxième technique en fonction d'un critère de fiabilité dépendant de la valeur de l'erreur statistique d'estimation d'un deuxième modèle (M2) correspondant au premier modèle (M1) corrigé par la fonction de correction pour la première valeur calculée de l'état de charge (SOC)
    - calculer la valeur calculée de l'état de charge (SOC) selon la technique déterminée comme fiable si la valeur n'a pas été calculée précédemment, et
    - sélectionner la valeur calculée de l'état de charge (SOC) selon la technique déterminée comme étant la valeur estimée de l'état de charge (SOC).

10. Calculateur selon la revendication 9, dans lequel le calculateur (22) est également propre à corriger la quantité de charge accumulée calculée utilisée par la deuxième technique pour que le calcul de la deuxième technique conduise à obtenir la première valeur calculée de l'état de charge (SOC) lorsque la première technique est déterminée comme fiable.

11. Système de gestion (14) d'au moins un élément électrochimique (12) d'une batterie (10), l'au moins un élément électrochimique (12) présentant des bornes, le système de gestion (14) comprenant :

   - un capteur de tension (16) propre à mesurer la tension aux bornes dudit au moins un élément électrochimique (12),
   - un capteur du courant (18) aux bornes dudit au moins un élément électrochimique (12),
   - un capteur de température (20) dudit au moins un élément électrochimique (12), et
   - un calculateur (22) selon la revendication 9 ou 10.

**12.** Batterie (10) comprenant :

   - au moins un élément électrochimique (12), et
   - un système de gestion (14) selon la revendication 11.

**Patentansprüche**

**1.** Verfahren zum Schätzen des Ladezustands (SOC) mindestens einer elektrochemischen Zelle (12) einer Batterie (10),

wobei das Verfahren von einem Rechner (22) durchgeführt wird, wobei der Rechner (22) ein erstes Modell (M1) speichert, das ausgehend von einem Spannungswert, einem Stromstärkewert, einem Temperaturwert und einem Kapazitätswert der mindestens einen elektrochemischen Zelle (12) den Wert des Ladezustands (SOC) der mindestens einen elektrochemischen Zelle (12) angibt, wobei das erste Modell (M1) ein gelerntes neuronales Netz ist, der Rechner (22) eine Korrekturfunktion speichert, die für jeden Wert des Ladezustands (SOC) den statistischen Fehler der Schätzung durch das erste Modell (M1) angibt,
das Verfahren umfassend für mehrere Zeitpunkte die folgenden Schritte:

   - Erlangen von Werten für die Spannung, die Stromstärke, die Temperatur und die Kapazität der mindestens einen elektrochemischen Zelle (12),
   - Berechnen des Werts des Ladezustands (SOC) der mindestens einen elektrochemischen Zelle (12) gemäß einer ersten Technik und einer zweiten Technik,

die erste Technik umfassend die folgenden Vorgänge:

   - Anwenden des ersten Modells auf den Spannungswert, der Stromstärke, der Temperatur und der Kapazität der mindestens eine elektrochemische Zelle (12) zum selben Zeitpunkt, um einen geschätzten Wert für den Ladezustand (SOC) zu erlangen, und
   - Anwenden der Korrekturfunktion auf den geschätzten Werts des Ladezustands, um einen ersten berechneten Wert des Ladezustands (SOC) zu erlangen,

die zweite Technik umfassend die folgenden Vorgänge:

   - Berechnen des Werts der akkumulierten Ladungsmenge durch Verwendung der erlangten Werte der Stromstärke,
   - Ableiten eines zweiten berechneten Werts des Ladezustands (SOC) durch Berechnen des Verhältnisses des Werts der akkumulierten Ladungsmenge und der Kapazität der mindestens einen elektrochemischen Zelle (12),

   - Bestimmen der zuverlässigsten Technik aus der ersten Technik und der zweiten Technik abhängig von einem Zuverlässigkeitskriterium, das von dem Wert des statistischen Fehler der Schätzung eines zweiten Modells (M2) abhängt, das dem ersten Modell (M1) entspricht, korrigiert durch die Korrekturfunktion für den ersten berechneten Wert des Ladezustands (SOC)
   - Berechnen des berechneten Werts des Ladezustands (SOC) gemäß der als zuverlässig bestimmten Technik, wenn der Wert nicht bereits zuvor berechnet worden ist, und
   - Auswählen des berechneten Werts des Ladezustands (SOC) gemäß der bestimmten Technik als den geschätzten Wert des Ladezustands (SOC).

**2.** Schätzverfahren nach Anspruch 1, wobei das Verfahren auch einen Schritt eines Korrigierens der berechneten akkumulierten Ladungsmenge umfasst, die von der zweiten Technik verwendet wird, damit die Berechnung der zweiten Technik dazu führt, den ersten berechneten Wert des Ladezustands (SOC) zu erlangen, wenn die erste Technik als zuverlässig bestimmt wird.

**3.** Schätzverfahren nach Anspruch 1 oder 2, wobei das Verfahren ferner einen Schritt eines Korrigierens des erlangten Werts der Stromstärke durch Subtraktion des Messfehlers der Stromstärke umfasst, um einen korrigierten Wert der Stromstärke zu erlangen, wobei die Berechnungsschritte auf den korrigierten Wert der Stromstärke angewendet werden.

**4.** Schätzverfahren nach Anspruch 3, wobei das Verfahren, wenn die erste Technik zu einem Zeitpunkt nach einem Zeitintervall, in dem die zweite Technik zu jedem Zeitpunkt des Zeitintervalls als zuverlässig bestimmt wurde, als zuverlässig bestimmt wird, ferner einen Schritt eines Bestimmens des Messfehlers der Stromstärke durch Verwendung der Differenz des Ladezustands zwischen den zwei Techniken seit dem Beginn des Zeitintervalls umfasst.

5. Schätzverfahren nach einem der Ansprüche 1 bis 4, wobei das neuronale Netz des ersten Modells (M1) ein mehrschichtiges Perzeptron ist.

6. Schätzverfahren nach einem der Ansprüche 1 bis 5, wobei das neuronale Netz des ersten Modells (M1) eine Anzahl von Neuronen umfasst, die kleiner als oder gleich wie 100 ist.

7. Schätzverfahren nach einem der Ansprüche 1 bis 6, wobei die mindestens eine elektrochemische Zelle (12), das eine Kennlinie Ladezustand (SOC) - Leerlaufspannung (OCV) mit einem ebenen Abschnitt aufweist, wobei ein ebener Abschnitt ein Abschnitt ist, in dem die Änderung der Leerlaufspannung (OCV) weniger als 30 mV bei einer Änderung des Ladezustands (SOC) um mindestens 10 % ist.

8. Schätzverfahren nach einem der Ansprüche 1 bis 7, wobei die mindestens eine elektrochemische Zelle (12) ein kathodisch aktives Material umfasst, das ausgewählt ist aus den folgenden Gruppen oder deren Gemischen:

i. einer Verbindung von Formel $Li_xFe_{1-y}M_yPO_4$ (LFMP), wobei M ausgewählt ist aus der Gruppe, bestehend aus B, Mg, Al, Si, Ca, Ti, V, Cr, Mn, Co, Ni, Cu, Zn, Y, Zr, Nb und Mo; und $0,8 \leq x \leq 1,2$; $0 \leq y \leq 0,6$,

ii. einer Verbindung von Formel $Li_xMn_{1-y-z}M'_yM''_zPO_4$ (LMP), wobei M' und M'' voneinander verschieden sind und ausgewählt sind aus der Gruppe, bestehend aus B, Mg, Al, Si, Ca, Ti, V, Cr, Fe, Co, Ni, Cu, Zn, Y, Zr, Nb und Mo, wobei $0,8 \leq x \leq 1,2$; $0 \leq y \leq 0,6$; $0,0 \leq z \leq 0,2$,

iii. einer Verbindung von Formel $Li_xMn_{2-y-z}Ni_yM_zO_{4-d-c}F_c$ (LMNO), wobei M ein oder mehrere Elemente darstellt, die ausgewählt sind aus der Gruppe, bestehend aus B, Mg, Al, Si, Ca, Ti, V, Cr, Fe, Co, Cu, Zn, Y, Zr, Nb, Ru, W und Mo; und $1 \leq x \leq 1,4$; $0 \leq y \leq 0,6$; $0 \leq z \leq 0,2$; $0 \leq d \leq 1$; $0 \leq c \leq 1$,

iv. einer Verbindung von Formel $Li_xMn_{2-y-z}M'_yM''_zO_4$ (LMO), wobei M' und M'' ausgewählt sind aus der Gruppe, bestehend aus B, Mg, Al, Si, Ca, Ti, V, Cr, Fe, Co, Ni, Cu, Zn, Y, Zr, Nb und Mo; wobei M' und M'' voneinander verschieden sind, und $1 \leq x \leq 1,4$; $0 \leq y \leq 0,6$; $0 \leq z \leq 0,2$, und

v. einer Verbindung von Formel $LiVPO_4F$ (LVPF).

9. Rechner (22), der geeignet ist, um den Ladezustand (SOC) mindestens einer elektrochemischen Zelle (12) einer Batterie (10) zu schätzen,

wobei der Rechner (22) ein erstes Modell (M1) speichert, das ausgehend von einem Spannungswert, einem Stromstärkewert, einem Temperaturwert und einem Kapazitätswert der mindestens einen elektrochemischen Zelle (12) den Wert des Ladezustands (SOC) der mindestens einen elektrochemischen Zelle (12) angibt, wobei das erste Modell (M1) ein gelerntes neuronales Netz ist, der Rechner (22) eine Korrekturfunktion speichert, die für jeden Wert des Ladezustands (SOC) den statistischen Fehler der Schätzung durch das erste Modell (M1) angibt,
wobei der Rechner (22) für mehrere Zeitpunkte zu Folgendem geeignet ist:

- Erlangen von Werten für die Spannung, die Stromstärke, die Temperatur und die Kapazität der mindestens einen elektrochemischen Zelle (12),
- Berechnen des Werts des Ladezustands (SOC) der mindestens einen elektrochemischen Zelle (12) gemäß einer ersten Technik und einer zweiten Technik,

die erste Technik umfassend die folgenden Vorgänge:

- Anwenden des ersten Modells auf den Spannungswert, der Stromstärke, der Temperatur und der Kapazität der mindestens eine elektrochemische Zelle (12) zum selben Zeitpunkt, um einen geschätzten Wert für den Ladezustand (SOC) zu erlangen, und
- Anwenden der Korrekturfunktion auf den geschätzten Werts des Ladezustands, um einen ersten berechneten Wert des Ladezustands (SOC) zu erlangen,

die zweite Technik umfassend die folgenden Vorgänge:

- Berechnen des Werts der akkumulierten Ladungsmenge durch Verwendung der erlangten Werte der Stromstärke,
- Ableiten eines zweiten berechneten Werts des Ladezustands (SOC) durch Berechnen des Verhältnisses des Werts der akkumulierten Ladungsmenge und der Kapazität der mindestens einen elektrochemischen Zelle (12),

- Bestimmen der zuverlässigsten Technik aus der ersten Technik und der zweiten Technik abhängig von einem Zuverlässigkeitskriterium, das von dem Wert des statistischen Fehler der Schätzung eines zweiten Modells (M2) abhängt, das dem ersten Modell (M1) entspricht, korrigiert durch die Korrekturfunktion für den ersten berechneten Wert des Ladezustands (SOC)
- Berechnen des berechneten Werts des Ladezustands (SOC) gemäß der als zuverlässig bestimmten Technik, wenn der Wert nicht bereits zuvor berechnet worden ist, und
- Auswählen des berechneten Werts des Ladezustands (SOC) gemäß der bestimmten Technik als den geschätzten Wert des Ladezustands (SOC).

10. Rechner nach Anspruch 9, wobei der Rechner (22) auch geeignet ist, um die berechnete akkumulierte Ladungsmenge, die von der zweiten Technik verwendet wird, zu korrigieren, damit die Berechnung der zweiten Technik dazu führt, den ersten berechneten Wert des Ladezustands (SOC) zu erlangen, wenn die erste Technik als zuverlässig bestimmt wird.

11. Managementsystem (14) mindestens einer elektrochemischen Zelle (12) einer Batterie (10), wobei die mindestens eine elektrochemische Zelle (12) Anschlüsse aufweist, das Managementsystem (14) umfassend:

- einen Spannungssensor (16), der geeignet ist, um die Spannung an der mindestens einen elektrochemischen Zelle (12) zu messen,
- einen Sensor der Stromstärke (18) an den Anschlüssen der mindestens einen elektrochemischen Zelle (12),
- einen Temperatursensor (20) der mindestens einen elektrochemischen Zelle (12), und
- einen Rechner (22) nach dem Anspruch 9 oder 10.

12. Batterie (10), umfassend:

- mindestens eine elektrochemische Zelle (12) und
- ein Managementsystem (14) nach Anspruch 11.

**Claims**

1. Method for estimating the state of charge (SOC) of at least one electrochemical element (12) of a battery (10),

the method being implemented by a calculator (22), the calculator (22) storing a first model (M1) giving from a value of voltage, a value of current, a value of temperature and a value of capacitance of the at least one electrochemical element (12) the value of the state of charge (SOC) of the at least one electrochemical element (12), the first model (M1) being a trained neural network, the calculator (22) storing a correction function giving, for each value of the state of charge (SOC), the statistical error of estimation by the first model (M1),
the method comprising, for a plurality of instants, the steps of:

- obtaining values of the voltage, the current, the temperature and the capacitance of at least one electrochemical element (12),
- computation of the value of the state of charge (SOC) of at least one electrochemical element (12) according to a first technique and a second technique,

the first technique including the following operations:

- application of the first model on the value of the voltage, the current, the temperature and the capacitance of the at least one electrochemical element (12) at the same instant, to obtain an estimated value of the state of charge (SOC), and
- application of the correction function to the estimated value of the state of charge (SOC), to obtain a first computed value of the state of charge (SOC),

the second technique including the following operations:

- computation of the value of the amount of charge accumulated by using the obtained values of current,
- deduction of a second computed value of the state of charge (SOC) by computing the ratio of the value of the accumulated charge quantity and the capacitance of the at least one electrochemical element (12),
- determination of the most reliable technique among the first technique and the second technique according to a reliability criterion depending on the value of the statistical error of estimation of the second model (M2) corresponding to the first model (M1) corrected by the correction function for the first computed value of the state of charge (SOC),
- computation of the computed value of the state of charge (SOC) according to the technique determined as being reliable if the value has not been computed previously, and

- selection of the computed value of the state of charge (SOC) according to the technique determined as the estimated value of the state of charge (SOC).

2. Method for estimating according to claim 1, wherein the method further includes a step of correcting the computed accumulated charge quantity used by the second technique so that the computation of the second technique leads to obtaining the first computed value of state of charge (SOC) when the first technique is determined as being reliable.

3. Method for estimating according to claim 1 or 2, wherein the method further includes a step of correcting the value of current obtained by subtracting the measurement bias on the current, in order to obtain a corrected value of the current, the steps of computation being applied to the corrected value of the current.

4. Method for estimating according to claim 3, wherein the method further includes, when the first technique is determined as being reliable at an instant after a time interval during which the second technique has been determined as being reliable at each instant in the time interval, a step of determining the measurement bias on the current by using the difference of state of charge between the two techniques since the beginning of the time interval.

5. Method for estimating according to any one of claims 1 to 4, wherein the neural network of the first model (M1) is a multilayer perceptron.

6. Method for estimating according to any one of claims 1 to 5, wherein the neural network of the first model (M1) includes a number of neurons less than or equal to 100.

7. Method for estimating according to any one of claims 1 to 6, wherein the at least one electrochemical element (12) having a state of charge (SOC) - open circuit voltage (OCV) characteristic with a flat portion, a flat portion being a portion wherein the variation of the open circuit voltage (OCV) is less than 30 mV for a variation of at least 10% of the state of charge (SOC).

8. Method for estimating according to any one of claims 1 to 7, wherein the at least one electrochemical element (12) comprises an active cathode material chosen from the following groups or mixtures thereof:

i) a compound with the formula $Li_xFe_{1-y}M_yPO_4$ (LFMP) where M is selected from the group consisting of B, Mg, Al, Si, Ca, Ti, V, Cr, Mn, Co, Ni, Cu, Zn, Y, Zr, Nb, and Mo; and $0.8 \leq x \leq 1.2$; $0 \leq y \leq 0.6$,

ii) a compound with the formula $Li_xMn_{1-y-z}M'_yM''_zPO_4$ (LMP), where M' and M" are different from each other and are selected from the group consisting of B, Mg, Al, Si, Ca, Ti, V, Cr, Fe, Co, Ni, Cu, Zn, Y, Zr, Nb, and Mo, with $0.8 \leq x \leq 1.2$; $0 \leq y \leq 0.6$; $0 \leq z \leq 0.2$;

iii) a compound with the formula $Li_xMn_{2-y-z}Ni_yM_zO_{4-d-c}F_c$ (LMNO), where M represents one or a plurality of elements chosen from the group consisting of B, Mg, Al, Si, Ca, Ti, V, Cr, Fe, Co, Ni, Cu, Zn, Y, Zr, Nb, and Mo; and $1 \leq x \leq 1.4$; $0 < y \leq 0.6$; $0 \leq z \leq 0.2$; $0 \leq d \leq 1$; $0 \leq c \leq 1$,

iv) a compound with the formula $Li_xMn_{2-y-z}M'_yM''_zO_4$ (LMO), where M' and M" are chosen from the group consisting of B, Mg, Al, Si, Ca, Ti, V, Cr, Fe, Co, Ni, Cu, Zn, Y, Zr, Nb, and Mo; M' and M" being different from each other, and $1 \leq x \leq 1.4$; $0 \leq y \leq 0.6$; $0 \leq z \leq 0.2$; and

v) a compound with the formula $LiVPO_4F$ (LVPF).

9. Calculator (22) adapted to estimate the state of charge (SOC) of at least one electrochemical element (12) of a battery (10),

the calculator (22) storing a first model (M1) giving from a value of voltage, a value of current, a value of temperature and a value of capacitance of the at least one electrochemical element (12) the value of the state of charge (SOC) of the at least one electrochemical element (12), the first model (M1) being a trained neural network, the calculator (22) storing a correction function giving, for each value of the state of charge (SOC), the statistical error of estimation by the first model (M1),
the calculator (22) being, for a plurality of instants, adapted to:

- obtain values of the voltage, the current, the temperature and the capacitance of at least one electrochemical element (12),
- compute the value of the state of charge (SOC) of a first technique and a second technique,

the first technique including the following operations:

- application of the first model on the value of the voltage, the current, the temperature and the capacitance of the at least one electrochemical element (12) at the same instant, to obtain an estimated value of the state of charge (SOC), and

- application of the correction function to the estimated value of the state of charge (SOC), to obtain a first computed value of the state of charge (SOC),

the second technique including the following operations:

- computation of the value of the amount of charge accumulated by using the obtained values of current,
- deduction of a second computed value of the state of charge (SOC) by computing the ratio of the value of the accumulated charge quantity and the capacitance of the at least one electrochemical element (12),
- determine the most reliable technique among the first technique and the second technique according to a reliability criterion depending on the value of the statistical error of estimation of the second model (M2) corresponding to the first model (M1) corrected by the correction function for the first computed value of the state of charge (SOC)
- compute the computed value of the state of charge (SOC) according to the technique determined to be reliable if the value has not been computed previously, and
- select the computed value of the state of charge (SOC) according to the technique determined as the estimated value of the state of charge (SOC).

10. Calculator according to claim 9, wherein the calculator (22) is also adapted to correct the computed accumulated charge quantity used by the second technique so that the computation of the second technique results in obtaining the first computed state of charge (SOC) value when the first technique is determined as being reliable.

11. System for managing (14) at least one electrochemical element (12) of a battery (10), the at least one electrochemical element (12) having terminals, the system for managing (14) comprising:

- a voltage sensor (16) adapted to measure the voltage at the terminals of at least one electrochemical element (12),
- a current voltage sensor (18) adapted to measure the current at the terminals of said at least one electrochemical element (12),
- a temperature sensor (20) adapted to measure the temperature of said at least one electrochemical element (12), and
- a calculator (22) according to claim 9 or 10.

12. Battery (10) comprising:

- at least one electrochemical element (12), and
- a system for managing (14) according to claim 11.

10

12

16

18

20

22

14

FIG.1

**FIG.2**

E30

E32

E34

P1

E40

E42

58

E44

E46

55

E48

E52

50

E54

P2

E56

60

## FIG.3

FIG.4

FIG.5

FIG.6

FIG.7

FIG.8

RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **DONG CHAO et al.** Estimation of Power battery SOC based on improved BP neural network. *2014 IEEE International Conference on Mechatronics and Automation*
- **PU CHI et al.** The ANN models for SOC/BRC estimation of li-ion battery. *2005 IEEE International Conference on Hong Kong and Macao, China*
- **HOW DICKSON N. T. et al.** State of Charge Estimation for Lithium-Ion Batteries Using Model-Based and Data-Dirven Methods: A Review. *IEEE Access*, vol. 7, 136116-136136